# EUROPÄISCHE PATENTSCHRIFT

(11) **EP 3 531 155 B1**
(45) Veröffentlichungstag und Bekanntmachung des Hinweises auf die Patenterteilung: **23.06.2021**
(21) Anmeldenummer: 19158555.3
(22) Anmeldetag: 21.02.2019
(51) Int. Cl.: G01R 33/30, G01R 33/422

(54) **NMR-PROBENKOPF MIT TRAGETEIL (BACKBONE) IM ABSCHIRMROHR**
NMR SAMPLE HEAD WITH A SUPPORTING SECTION (BACKBONE) IN SHIELD TUBE
TÊTE DE SONDE RMN POURVUE DE PARTIE DE SUPPORT (ÉPINE DORSALE) DANS UN TUBE DE PROTECTION

(30) Priorität: 26.02.2018 DE 102018202890
(43) Veröffentlichungstag der Anmeldung: 28.08.2019
(73) Patentinhaber: Bruker BioSpin GmbH, 76287 Rheinstetten (DE)
(72) Erfinder: Bandara, Priyanga, 76228 Karlsruhe (DE); Haueisen, Ralf, 76187 Karlsruhe (DE); Ganz, Jürgen, 76275 Ettlingen (DE); Osen, David, 76275 Ettlingen (DE); Armbruster, Martin, 77855 Achern (DE); Krahn, Alexander, 76137 Karlsruhe (DE)
(74) Vertreter: Kohler Schmid Möbus Patentanwälte

(56) Entgegenhaltungen:
- DE-B3-102013 201 110
- VOLKER C. BEHR ET AL: "A novel modular probe base design", CONCEPTS IN MAGNETIC RESONANCE PART B: MAGNETIC RESONANCE ENGINEERING, Bd. 33B, Nr. 1, 2008, Seiten 55-61, XP055602704, US ISSN: 1552-5031, DOI: 10.1002/cmr.b.20107
- Volker Behr: "Probenköpfe", Entwicklung und Optimierung von Resonatoren und Detektionsverfahren in der magnetischen Kernspinresonanz, 2008, Seiten 73-84, XP055602858, Internet Gefunden im Internet: URL:https://opus.bibliothek.uni-wuerzburg. de/opus4-wuerzburg/frontdoor/deliver/index /docId/2453/file/diss.pdf [gefunden am 2019-07-05]

## Beschreibung

Die Erfindung betrifft einen NMR(=Kernspinresonanz)-Probenkopf zum Einführen in eine Magnetbohrung eines NMR-Magnetsystems, wobei der NMR-Probenkopf in einem Spulenbereich eine HF-Spulenanordnung umfasst, die zum Einstrahlen von HF-Pulsen in eine NMR-Messprobe und/oder zum Empfangen von HF-Signalen aus der NMR-Messprobe dient und in einem NMR-Messbetriebszustand in einem Messbereich um ein magnetisches Zentrum innerhalb der Magnetbohrung angeordnet ist, wobei der NMR-Probenkopf ein längliches Abschirmrohr aus elektrisch leitfähigem Material zum Abschirmen gegen äußere HF-Strahlung umfasst, welches die elektrischen, mechanischen und HF-Bauteile des NMR-Probenkopfes umgibt und durch welches Zuleitungen von einem im NMR-Messbetriebszustand außerhalb des Messbereiches angeordneten Anschlussbereich zum Spulenbereich geführt sind, wobei innerhalb des Abschirmrohrs ein längliches Trageteil angeordnet ist, welches eine eigensteife, mechanisch starre Struktur mit durchgängigen, im Wesentlichen parallel zur Längsachse des Abschirmrohrs verlaufenden Bohrungen und/oder Verbindungskanälen aufweist, die im Anschlussbereich elektrische Zuleitungen aufnehmen und zum Spulenbereich führen, und wobei das längliche Trageteil eine vom Anschlussbereich bis zum Spulenbereich führende durchgehend elektrisch leitfähige äußere Oberfläche aufweist.

Ein solcher NMR-Probenkopf, allerdings ohne parallel zur Längsachse des Abschirmrohrs verlaufende Bohrungen, ist bekannt aus Volker C. Behr ET AL: "A novel modular probe base design", CONCEPTS IN MAGNETIC RESONANCE PART B: MAGNETIC RESONANCE ENGINEERING, Bd. 33B, Nr. 1, 1. Januar 2008 (2008-01-01), Seiten 55-61, US ISSN: 1552-5031, D01: 10.1002/cmr.b.20107 (= Referenz [0]).

Ein ähnlicher NMR-Probenkopf ist beispielsweise bekannt aus der DE 10 2013 201 110 B3 (= Referenz [1]).

### Hintergrund der Erfindung

Die NMR-Spektroskopie ist ein leistungsfähiges Verfahren der instrumentellen Analytik, mit dem insbesondere die chemische Zusammensetzung von Messproben bestimmt werden kann. Dabei werden HF(=Hochfrequenz)-Pulse in die Messprobe, die sich in einem starken statischen Magnetfeld befindet, eingestrahlt, und die elektromagnetische Reaktion der Probe wird vermessen.

Zur Verringerung von Linienverbreiterungen aufgrund anisotroper Wechselwirkungen ist es zudem bekannt, eine NMR-Probe aus Feststoffen während der spektroskopischen Vermessung unter dem so genannten "Magischen Winkel" von ca. 54,74° gegenüber dem statischen Magnetfeld verkippt rotieren zu lassen ("MAS" = Magic Angle Spinning Der MAS-Rotor wird in einem MAS-Stator gasgelagert angeordnet, temperiert und mit einem zweiten Gasstrom in Rotation versetzt. Das bedeutet, dass NMR-MAS Probenköpfe einen mit Druckluft betriebenen Stator umfassen, welcher mehrere voneinander getrennte Druckgaszufuhren für die genannten Zwecke umfasst, die typischerweise von einem Fußkasten des Probenkopfes bis hin zum Messbereich, dem eigentlichen MAS-Modul, geführt werden.

Die vorliegende Erfindung betrifft einen NMR-Probenkopf (also allgemein auch für NMR-Anwendungen ohne MAS) zur Einbringung in die Bohrung des Magnetsystems eines NMR-Spektrometers. Zentrales Bauteil im Probenkopf ist der Resonator, mit welchem das Signal der Messprobe empfangen wird. Typischerweise ist das Signal relativ schwach und dementsprechend ist es eines der wichtigsten Ziele, die Empfindlichkeit zu erhöhen. Erschwerend kommt hinzu, dass elektromagnetische Felder, die von außen in die Messanordnung eindringen, die Qualität der Messung zusätzlich beeinflussen.

Um das HF-Netzwerk der NMR-Anordnung gegenüber der Umgebung elektromagnetisch abzuschirmen, wird -praktisch immer- eine HF-Dichtung eingesetzt. Der Probenkopf verfügt daher über ein in der Regel zylindrisches Abschirmrohr, in welchem HF-Elektronik-Bauteile, insbesondere HF-Resonatorspulen, und gegebenenfalls die MAS-Turbine untergebracht sind, wobei die MAS-Turbine im Bereich des vom Fußkasten abgewandten Endes des Abschirmrohres angeordnet ist. Der Probenkopf wird mit seinem Abschirmrohr typischerweise von unten in die vertikale RaumtemperaturBohrung eines zumeist supraleitenden Magneten eingeführt, positioniert, und mit Haken, Stützen, Schrauben oder dergleichen gehalten. Die NMR Probe bzw. die MAS-Turbine befindet sich dann genau im magnetischen Zentrum des Magneten.

Bei dem in der US 5,262,727 A (= Referenz [2]) verwendeten Konzept ist die HF-Dichtung ganz unten bei einer Basisscheibe platziert, wobei allerdings keine vollständige Abdichtung gewährleistet ist. Neben der HF-Dichtigkeit ist allerdings auch ein guter elektrischer Massekontakt erwünscht. In diesem Stand der Technik ist es jedoch nicht sicher, ob damit eine absolute Abdichtung gewährleistet werden kann. Referenz [2] offenbart insbesondere eine HF-Abschirmung einer HF Spule in einem NMR Probenkopf umfassend zylindrischen Abschirmungen und Abschirmscheiben, welche die Messprobe umgeben. Nachteilig sind hierbei die zusätzlich erforderlichen Bauteile, die für MAS-Anwendungen schlecht geeignet sind. Es ist kein starrer Backbone, insbesondere kein Wabenkamin vorhanden.

US 6,329,820 B1 (= Referenz [3]) beschreibt einen NMR-Probenkopf mit Abschirmrohr und einer metallisch beschichteten Trennplatte zum Zwecke der Abschirmung. Das Abschirmrohr ist fest verbunden durch angelötete Metalldrähte. Ein separates Trageteil oder ein abnehmbares Abschirmrohr sind nicht offenbart.

In Patent Abstracts of Japan 05307073 A (= Referenz [4]) ist eine HF-Abschirmung für einen NMR Probenkopf beschrieben, die ein als Rundwellenleiter ausgebildetes Abschirmrohr aufweist, das zur HF-Dämpfung entsprechend dimensioniert ist. Der Probenkopf umfasst jedoch kein separates mechanisches Trageteil.

Die deutsche Patentanmeldung DE 10 2017 208 841.9 (= Referenz [5]) einer Schwesterfirma der Anmelderin war zum vorliegenden Anmeldetag noch unveröffentlicht. Bei diesem Konzept der sogenannten iProbe ist die HF-Dichtung aus konzeptionellen Gründen auf halber Höhe platziert worden. Dieser NMR Probenkopf umfasst eine Einrichtung zum Abschirmen gegen äußere HF-Strahlung mit einem elektrisch leitfähigen, längs der z-Achse angeordneten Abschirmrohr, das um die HF-Spulen und das HF-Netzwerk in z-Richtung auf eine Basisscheibe geschoben werden kann. Mit axialem Abstand von der Basisscheibe ist eine Abschirmscheibe vorgesehen und zwischen der Abschirmscheibe und dem Abschirmrohr im montierten Zustand ist eine spannbare HF-Dichtung angeordnet, die geometrisch so gestaltet ist, dass in einem ersten Montagezustand das Abschirmrohr unverspannt und kraftfrei über die die Abschirmscheibe geschoben werden kann, und dass in einem zweiten Montagezustand die HF-Dichtung zwischen der Abschirmscheibe und dem Abschirmrohr mechanisch derart verspannbar ist, dass eine elektrisch leitende Verbindung zum Abschirmrohr über den Umfang der Abschirmscheibe gewährleistet ist. Nachteilig ist hier allerdings die aufwändige Fertigung der HF-Dichtung.

Des Weiteren bedarf es aber auch noch zusätzlicher struktureller Bauteile, die dem Probenkopf die erforderliche Stabilität verschaffen, sodass die Messprobe (bei MAS-Anwendungen der MAS-Rotor) immer im optimalen Bereich (und für die MAS auch im genauen magischen Winkel) des Magneten befindlich sind. Herkömmlicherweise werden starre metallische Stangen als Verbindungen des Stators mit dem Fußkasten verwendet, die in regelmäßigen Abständen mit metallischen Trägerplatten versehen sind (sogenannter "Rahmen"). Diese Struktur bietet die geforderte mechanische Stabilität. Der Nachteil besteht hier aber darin, dass sowohl die Trägerplatten als auch alle Verbindungsstangen in engen Abständen mit dem umgebenden Abschirmrohr elektrisch leitfähig verbunden werden müssen. Ohne diese Erdung gäbe käme es zur Anregung von Eigenresonanzen der Rahmenelemente durch die interne Probenkopf-Schaltung ("interne Störungen") und zur Einkopplung von externen Störsignalen bis zur Probenkammer ("externe Störungen"). Letzteres wird dadurch verursacht, dass das Vorhandensein von nicht-geerdeten metallischen Komponenten innerhalb des Abschirmrohrs seine sogenannte cut-off Frequenz reduziert mit der Folge, dass alle Störungen am offenen Ende des Rohres in sein Inneres geleitet werden.

US 2014/0167756 A1 (= Referenz [6]) offenbart einen NMR-MAS-Probenkopf, in welchem die typische komplizierte Struktur der zahlreichen Verbindungsleitungen, Trimmer, etc. zwischen Fußkasten und MAS-Modul sowie die räumliche Nähe mechanischer und elektronischer Bauteile zu erkennen sind. Diese Ausführungsform stellt den "klassischen" Aufbau eines NMR-MAS Probenkopfes dar.

DE 10 2005 025 012 B4 (= Referenz [7]) beschreibt einen modularen MRI-Probenkopf, wobei ein Basisteil sowie Kanalmodule gemeinsam einen länglichen Aufbau aufweisen, wobei die Kanalmodule Durchführungen enthalten, durch welche HF-Bauteile, aber auch Versorgungsgase durchgeleitet werden können. Dier hier vorgestellte Probenkopf ist nicht aus leitfähigem Material hergestellt, er dient auch nicht der Trennung von mechanischen und elektronischen Bauteilen, da er nicht für die Verwendung in der NMR-MAS Technik konzipiert ist.

Die eingangs zitierte Referenz [1] offenbart einen NMR-MAS- Probenkopf mit einer Transportleitung für die Messprobe, die von unten her in den MAS-Stator gebracht wird. Die Schrift offenbart in Abschnitt [0052], dass im Inneren des Rohres ein Probenkopf Rahmen ausgebildet ist, auf dem der Stator und diverse elektronische Komponenten (nicht gesondert dargestellt) für eine NMR-Messung an einer im Stator angeordneten Messprobe angeordnet sind. Der erste Abschnitt der Transportleitung ist hier als ein starres Rohr ausgebildet, wodurch das Gestell eine gegenüber dem bis dahin bekannten Stand der Technik verbesserte Stabilität erreicht.

Wünschenswert wäre demgegenüber aber auch eine räumliche Trennung der mechanischen Tragekonstruktion und der Zuleitungen von den elektronischen Bauteilen, insbesondere den HF-Bauteilen im Probenkopf bei gleichzeitiger Vereinfachung der Bauweise und einem Zugewinn an Stabilität.

### Aufgabe der Erfindung

Der vorliegenden Erfindung liegt daher die Aufgabe zugrunde, einen NMR-Probenkopf der eingangs definierten Art gegen einströmende und einstrahlende HF-Felder von außen abzuschirmen und diese derart zu dämpfen, dass die NMR Messung nicht signifikant beeinflusst wird. Dies soll ohne einen erheblichen konstruktiven Aufwand geschehen. Des Weiteren soll ein möglichst großer Freiraum für die Detektionselektronik entstehen, ohne dass zusätzliche Bauteile wie etwa Abschirmplatten den Raum einschränken. Unterhalb der Detektionselektronik werden zur Verstellung der Elektronik-Komponenten ausschließlich elektrisch isolierende Materialien verwendet. Das Abschirmrohr soll abnehmbar sein.

### Kurze Beschreibung der Erfindung

Diese komplexe Aufgabe wird auf ebenso überraschend einfache wie wirkungsvolle Weise dadurch gelöst, dass die vom Anschlussbereich bis zum Spulenbereich führende durchgehend elektrisch leitfähige äußere Oberfläche des länglichen Tragteils mit der elektrisch leitfähigen Innenfläche des Abschirmrohrs über elektrisch leitfähige Verbindungselemente elektrisch leitend verbunden ist, und dass Trageteil und Abschirmrohr so miteinander verbunden sind, dass sich eine zusammenhängende elektrisch leitfähige Kontur ausbildet, die vom Spulenbereich bis zum Anschlussbereich verläuft und die Funktion eines Wabenkamins zur Dämpfung elektromagnetischer Felder hat.

Die vorliegende Erfindung beruht auf der Grundlage eines derart aufgebauten NMR-Probenkopfes, dass konstruktiv über den elektronischen -im Falle von MAS-Anwendungen auch mechanischen- Bauteile und Zuleitungen ein Abschirmrohr vorhanden ist, wie im Stand der Technik bereits beschrieben. Nun werden innerhalb des Probenkopfes vom Anschlussbereich her eine Mehrzahl von Zuleitungen und elektrischer Verbindungen, wie Kabel etc. hin zur Detektionselektronik im Anschlussbereich (gegebenenfalls zum MAS Stator im Magnetzentrum) geführt. Diese elektrischen Leiter innerhalb des als Hohlleiter ausgebildeten Abschirmrohrs bewirken, dass quasi ein Koaxialleiter entsteht, so dass HF-Wellen jeder Frequenz gut übertragen werden.

Alle elektrischen Leiter, mit Ausnahme der Innenleiter von Koaxialkabeln, werden auf diese Weise mit dem Abschirmrohr verbunden, so dass sich eine wegzusammenhängende Querschnittsfläche ergibt. Über eine ausreichende Länge wird der Probenkopf mit dieser Querschnittsfläche ausgeführt.

Die Zwischenräume bilden Wellenleiter, deren Grenzfrequenz oberhalb der Nutzfrequenz liegt. Die in der NMR-Technik verwendeten Frequenzen liegen je nach zu vermessendem Isotop und je nach angelegtem B₀-Feld zwischen 1MHz bis etwa 1GHz. Die Querschnittfläche und die Länge werden so gestaltet, dass sich in diesem Frequenzbereich eine Dämpfung von mehr als 60dB ergibt.

Daher wird erfindungsgemäß ein längliches Trageteil ("Backbone") vorgeschlagen, welches innerhalb des Abschirmrohrs angeordnet ist, welches eine eigensteife, mechanisch starre Struktur aufweist. Diese enthält durchgängige, im Wesentlichen parallel zur Längsachse des Abschirmrohrs verlaufende Bohrungen und/oder Verbindungskanälen, die im Anschlussbereich der Anordnung, gegebenenfalls am Fußkasten, die elektrischen und elektronischen -sowie insbesondere im Falle von NMR-MAS Probenköpfen auch pneumatischen und thermischen- Zuleitungen aufnehmen und zum Magnetzentrum (gegebenenfalls zum MAS-Modul) führen. Das längliche Trageteil weist darüber hinaus eine vom Anschlussbereich bis zum Spulenbereich (gegebenenfalls vom Fußkasten zum MAS-Modul) führende, durchgehend elektrisch leitfähige äußere Oberfläche auf, die mit der elektrisch leitenden Innenfläche des Abschirmrohrs verbunden ist. Dadurch entsteht eine zusammenhängende elektrische Kontur, die sich in z-Richtung erstreckt und die Funktion eines Wabenkamins zur Dämpfung elektromagnetischer Felder hat.

An dieser Stelle sei ausdrücklich darauf hingewiesen, dass sich die Vorteile der Erfindung nicht nur bei vertikalen NMR-Spektrometern, sondern ebenso auch bei NMR-Systemen mit horizontaler oder schräg liegender z-Achse erzielen lassen. Die angegebenen axialen Positionen müssen dann nicht mehr notwendig "oberhalb" beziehungsweise "unterhalb" des NMR-Magnetsystems liegen, sondern gegebenenfalls auch "rechts" oder "links" neben demselben. Jedenfalls spielt die Schwerkraft bei der Wirkungsweise der vorliegenden Erfindung eine eher untergeordnete Rolle.

### Bevorzugte Ausführungsformen der Erfindung

Wie bisher allgemein im Stand der Technik üblich, kann der Anschlussbereich des erfindungsgemäßen NMR-Probenkopfes als ein Fußkasten ausgebildet sein, wie er insbesondere bei MAS-Anwendungen verwendet wird.

Bevorzugt sind auch Ausführungsformen der Erfindung, bei denen die gemeinsame elektrische Kontur zwischen Trageteil und Abschirmrohr mehrere Wellenleiter parallel zur Rohrachse des Abschirmrohrs umfasst, die in ihrer Querschnittsfläche so dimensioniert sind, dass jeder Wellenleiter eine Grenzfrequenz aufweist, die oberhalb der höchsten Messfrequenz des NMR-Probenkopfes liegt. Der bei der NMR-Technik verwendete nutzbare Frequenzbereich liegt je nach Isotop und Magnetfeldstärke in einem Bereich von 1kHz bis 1,5GHz. Die Dimensionierung und Geometrie der Querschnittsfläche ist dabei nicht zwingend vorgegeben, sondern es kommt vielmehr auf das zu erreichende Dämpfungsergebnis an, das der zuständige Durchschnittsfachmann durch die obigen Vorgaben und mittels geeigneter Maßnahmen aufgrund seiner Fachkenntnisse problemlos erreichen kann.

Vorteilhafte Weiterbildungen dieser Ausführungsformen zeichnen sich dadurch aus, dass die Länge der Wellenleiter, die sich aus der gemeinsamen elektrischen Kontur ergeben, derart gewählt ist, dass elektromagnetische Wellen um mehr als 60dB gedämpft sind. Vorzugsweise liegt die Dämpfung bei mehr als 80dB, besonders bevorzugt bei mehr als 120dB.

Typischerweise fällt die Welle innerhalb des Wellenleiters unterhalb der Grenzfrequenz exponentiell ab. Die Dämpfungsstrecke hängt aber von mehreren Faktoren ab. Wesentlich ist die Querschnittsgeometrie und -fläche, es können aber auch weitere Effekte aufgrund der Geometrie die Dämpfungsstrecke beeinflussen, wenn z. B. der Abstand zweier benachbarter leitfähiger Flächen innerhalb der Kontur relativ gering ist (z.B. 1mm oder kleiner) und sich eine durchgehende stegförmige Querschnittsverengung der Hohlleitung ausbildet, die als kapazitive Belastung wirkt, so kann die Grenzfrequenz erniedrigt werden. Daher ist es schwierig in Parametern anzugeben, wie lang die Dämpfungsstrecke sein muss, denn das hängt von der vorgegebenen Geometrie ab.

Bei einem Rundhohlleiter ergibt sich beispielsweise eine Dämpfung von 120dB, wenn das Verhältnis von Länge zu Durchmesser des Wellenleiters mindestens 5:1 beträgt.

Bei Wellenleitern mit unbestimmten Geometrien wird die Dämpfungsstrecke in zwei Schritten bestimmt: Kennt man die Querschnittsfläche des Hohlleiters, so kann man die Grenzfrequenz bestimmen, und anschließend muss die Länge angepasst werden, so dass die Dämpfung den Vorgaben entspricht.

Vorzugsweise ist der Querschnitt der Wellenleiter so gewählt, dass eine ausreichende Dämpfung bei einer Dämpfungsstrecke von etwa 20cm gewährleistet ist.

Ganz besonders bevorzugte Ausführungsformen des erfindungsgemäßen Probenkopfs zeichnen sich dadurch aus, der NMR-Probenkopf als NMR-MAS Probenkopf ausgebildet ist und einen im NMR-Messbetriebszustand innerhalb des Messbereichs angeordneten MAS-Modul mit einem MAS-Stator umfasst, in welchem während einer NMR-Messung ein MAS-Rotor einschließlich einer NMR-Messprobe Druckgas-gelagert und temperierbar positioniert ist und mit Hilfe eines Gasstroms rotiert werden kann. Damit können die vielfältigen Vorteile der MAS-Technik genutzt werden.

Weitere vorteilhafte Ausführungsformen der Erfindung sehen vor, dass die Verbindungskanäle auch, vorzugsweise sämtliche, pneumatischen und thermischen Zuleitungen aufnehmen und vom Anschlussbereich bis zum Spulenbereich führen. Herkömmlicherweise werden bei MAS Probenköpfen diese Transportleitungen mit Kunststoffschläuchen zum MAS-Stator geführt, was zum einen bislang Ursache für einen recht komplizierten Aufbau des Probenkopfes war. Zum anderen sind diese Leitungen und Schläuche aber auch Ursache für Störungen im Betrieb, wie z.B. Hochspannungsüberschläge oder Vibrationen durch die Druckgaserzeugung. Das alles fällt nunmehr weg, wenn die Gaskanäle im erfindungsgemäßen Backbone aufgehoben sind.

In der Praxis bewähren sich Weiterbildungen dieser Ausführungsformen, bei denen im MAS-Modul-seitigen Ende des Trageteils eine als Adaptereinrichtung gestaltete Verteilerkappe angeordnet ist, welche die Enden der durchgängigen Bohrungen und/oder Verbindungskanäle des Trageteils mit entsprechenden Anschlüssen für die elektrischen sowie auch die pneumatischen und thermischen Zuleitungen am MAS-Modul, vorzugsweise pneumatisch und thermisch dichtend.

Von praktischem Vorteil sind auch Ausführungsformen des erfindungsgemäßen NMR-Probenkopfes, die sich dadurch auszeichnen, dass die vom Anschlussbereich bis zum Spulenbereich führende, durchgehend elektrisch leitfähige äußere Oberfläche mittels eines Massebands mit dem Erdpotential elektrisch verbunden ist, um einen guten elektrischen Massekontakt sicherzustellen.

Bei einer Klasse von vorteilhaften Ausführungsformen des erfindungsgemäßen Probenkopfes ist das längliche Trageteil einstückig aufgebaut. Es verbindet den Anschlussbereich (gegebenenfalls den Fußkasten) mit dem Spulenbereich (gegebenenfalls mit dem MAS-Modul).

Bevorzugt sind Weiterbildungen dieser Klasse von Ausführungsformen, bei denen das längliche Trageteil eine im Querschnitt gewinkelte oder abgerundete, konkave Struktur aufweist. Vorteilhaft bei einer solchen gewinkelten Struktur kann sein, dass die elastischen Kontaktelemente beidseitig an im Wesentlichen gegenüberliegenden Seiten angebracht sind und somit das Abschirmrohr zusätzlich verspannen und einen besseren Massekontakt zum Abschirmrohr herstellen.

Vorzugsweise sollten die Querschnitte in einem Abstand von mindestens 1mm angeordnet sein, dass sich keine sogenannte Steghohlleitung ausbildet.

Besonders bevorzugt wird in der Praxis das längliche Trageteil insgesamt aus leitfähigem Material, vorzugsweise aus Metall, aufgebaut sein.

Vorteilhaft ist eine Variante dieser Weiterbildungen, bei der das längliche Trageteil aus einem Strangpressprofil oder Druckprofil mit integrierten durchgehenden Kanälen für pneumatische, elektrische und/oder thermische Verbindungen aufgebaut ist.

Eine besonders bevorzugte Ausführungsform, sieht vor, dass beim erfindungsgemäßen NMR-Probenkopf das längliche Trageteil gemeinsam mit dem Abschirmrohr gegen die Umgebung zumindest pneumatisch, vorzugsweise auch thermisch, abgedichtet ist.

Bei weiteren bevorzugten Ausführungsformen der Erfindung weist das längliche Trageteil Querbohrungen auf, an welchen weitere Bauteile des NMR-Probenkopfes befestigt werden können. Die Querbohrungen können beispielsweise dazu dienen, dass eine leitfähige Platine, bevorzugt aus Kupfer, am Trageteil angebracht wird. An einer Kupferplatine können beispielsweise die Antennenkabel zur HF-Spule angelötet werden, wenn das auf dem Grundkörpermaterial des Trageteils nicht möglich ist. Das Trageteil kann auch aus Aluminium gebildet sein, das allerdings nur schwer lötbar ist.

Bevorzugt ist auch eine Weiterbildung dieser obigen Ausführungsformen, bei der die Querbohrungen auf ganzer Länge des Trageteils, vorzugsweise in regelmäßigen axialen Abständen, vorgesehen sind.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert.

Es zeigen:
- Fig. 1: eine schematische, aufgeschnittene Darstellung einer einfachen Ausführungsform des erfindungsgemäßen NMR-Probenkopfes;
- Fig. 2: eine vergrößerte schematische Querschnittdarstellung in der Ebene A-A durch das Abschirmrohr der Ausführungsform von Fig. 1 mit Trageteil und Wellenleitern;
- Fig. 3: eine räumliche Darstellung einer weiteren Ausführungsform des erfindungsgemäß ausgestalteten Tragteils von schräg oben;
- Fig. 4: eine schematische, längs aufgeschnittene Teil-Darstellung eines erfindungsgemäßen Probenkopfes mit MAS-Modul; und
- Fig. 5: einen schematischen Vertikalschnitt durch eine NMR-Apparatur nach dem Stand der Technik mit von unten in die Raumtemperaturbohrung des Magneten eingeführtem Probenkopf.

Die vorliegende Erfindung befasst sich mit einem speziell modifizierten Probenkopf für ein NMR-Spektrometer, insbesondere auch für MAS-Anwendungen, bei welchem eine räumliche Trennung der mechanischen Tragekonstruktion und der Zuleitungen von den elektronischen und HF-Bauteilen erzielt wird.

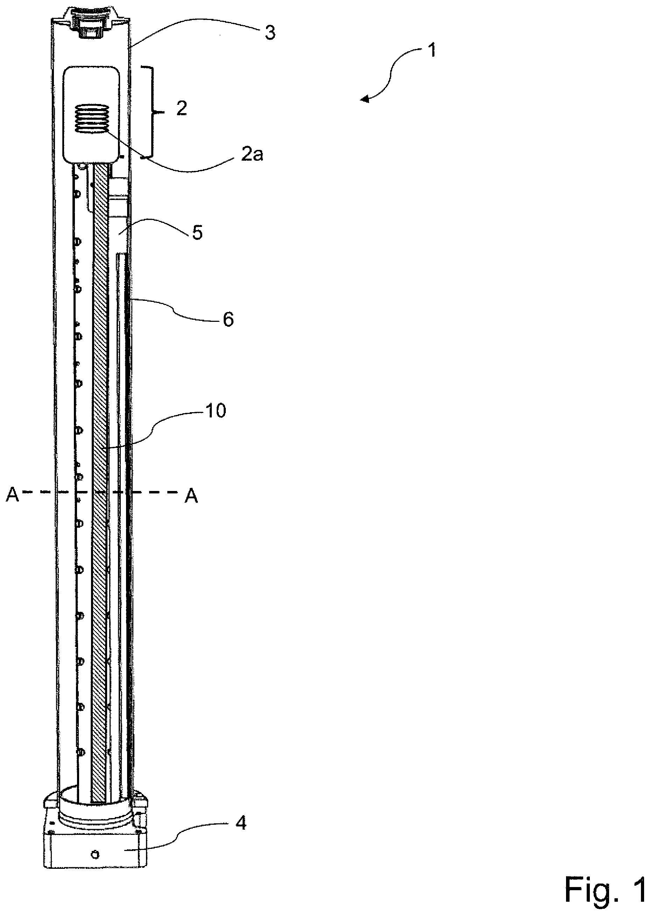

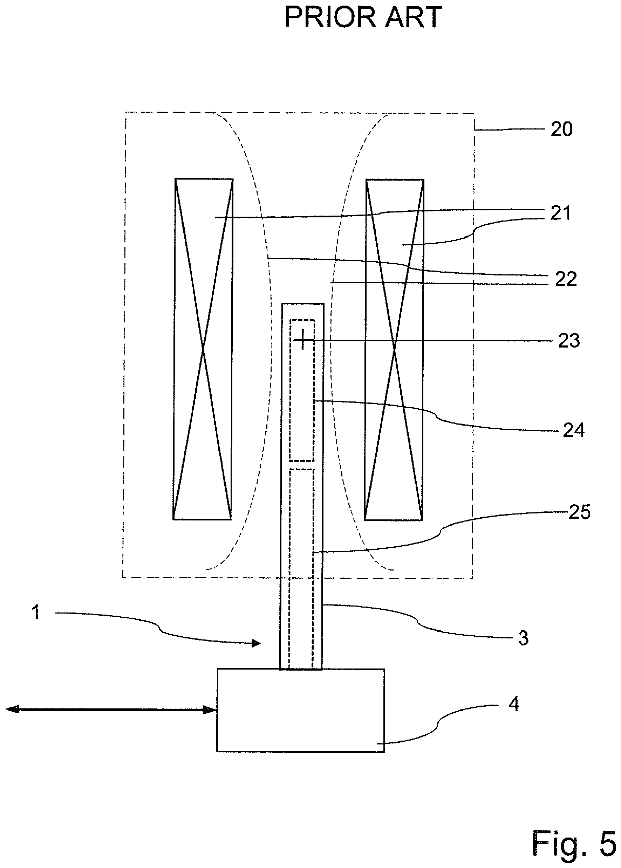

Die bewusst sehr schematisch gehaltene **Figur 1** zeigt in einer vertikalen Schnittebene einen erfindungsgemäßen **NMR-Probenkopf 1** zum Einführen in eine Magnetbohrung eines NMR-Magnetsystems 20, wie es etwa in **Figur 5** schematisch dargestellt ist. Der Probenkopf 1 umfasst in einem **Spulenbereich 2** eine **HF-Spulenanordnung 2a,** die zum Einstrahlen von HF-Pulsen in eine NMR-Messprobe und/oder zum Empfangen von HF-Signalen aus der NMR-Messprobe dient und in einem NMR-Messbetriebszustand in einem Messbereich um ein magnetisches Zentrum 23 innerhalb der Magnetbohrung des NMR-Magnetsystems 20 angeordnet ist. Zudem ist ein längliches **Abschirmrohr 3** aus elektrisch leitfähigem Material zum Abschirmen gegen äußere HF-Strahlung umfasst, welches mit seiner Rohrachse im Wesentlichen parallel zur z-Achse der NMR-Anordnung verläuft. Das Abschirmrohr 3 umgibt die elektrischen, mechanischen und HF-Bauteile des NMR-Probenkopfes 1 möglichst vollständig und Zuleitungen von einem im NMR-Messbetriebszustand außerhalb des Messbereiches angeordneten **Anschlussbereich 4** zum Spulenbereich 2 sind durch das Abschirmrohr 3 geführt.

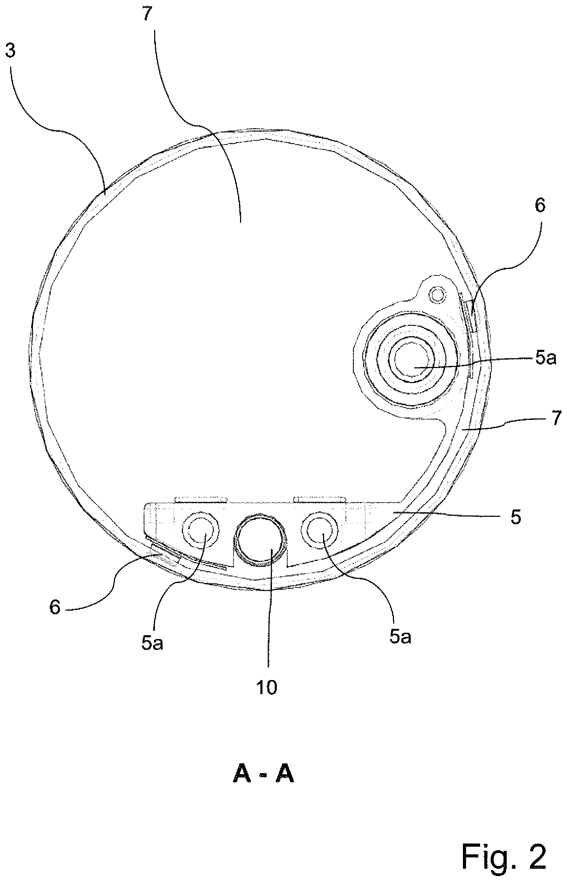

Erfindungsgemäß zeichnet sich der NMR-Probenkopf 1 gegenüber dem bekannten Stand der Technik dadurch aus, dass innerhalb des Abschirmrohrs 3 ein längliches **Trageteil 5** angeordnet ist, welches eine eigensteife, mechanisch starre Struktur mit durchgängigen, im Wesentlichen parallel zur Längsachse des Abschirmrohrs 3 verlaufenden **Bohrungen und/oder Verbindungskanälen 5a** -wie sie in **Figur 2** dargestellt sind- aufweist, die im Anschlussbereich 4 elektrische Zuleitungen aufnehmen und zum Spulenbereich 2 führen. Außerdem weist das längliche Trageteil 5 eine vom Anschlussbereich 4 bis zum Spulenbereich 2 führende durchgehend elektrisch leitfähige äußere Oberfläche auf, die mit der elektrisch leitfähigen Innenfläche des Abschirmrohrs 3 über **elektrisch leitfähige Verbindungselemente 6** elektrisch leitend verbunden ist, sodass zwischen Trageteil 5 und Abschirmrohr 3 eine zusammenhängende elektrisch leitfähige Kontur ausgebildet ist.

Als elektrisch leitfähige Verbindungselemente 6 vom Trageteil 5 zum Abschirmrohr 3 können beispielsweise leitfähige Kunststoffe oder mit leitfähigem Gewebe überzogene Schaumstoffe verwendet werden. Diese haben allerdings den Nachteil, dass der Übergangswiderstand relativ groß ist. Daher werden bevorzugt Kupfer- oder Kupferberylliumfedern eingesetzt und zwar in einem Abstand von vorzugsweise 0,5cm bis maxima! 2cm, bevorzugt auf ganzer Länge des Trageteils 5.

Wie bei dem in **Figur 2** dargestellten -nicht notwendig maßstäblichenhorizontalen Querschnitt in der Ebene A-A der Ausführungsform nach Fig. 1 durch das Abschirmrohr 3 in einer Ebene senkrecht zur Rohrachse gut zu erkennen ist, führt durch das längliche Trageteil 5 eine Vielzahl von Bohrungen und Verbindungskanälen 5a, welche parallel zur Rohrachse verlaufen. Beispielsweise kann die etwas größere Bohrung 5a im rechten Teil der Figur als ein Dewar-Kanal ausgebildet sein, während die kleineren Bohrungen 5a auf der unteren Bildseite als Rund-Hohlleiter ausgebildete Luftkanäle darstellen, durch welche andere Zuleitungen führen können.

Wichtig ist, dass die gemeinsame elektrische Kontur zwischen Trageteil 5 und Abschirmrohr 3 mehrere -in der Regel mit Luft gefüllte- **Wellenleiter 7** parallel zur Rohrachse des Abschirmrohrs 3 darstellt, die in ihrer Querschnittsfläche so dimensioniert sind, dass jeder Wellenleiter 7 eine Grenzfrequenz aufweist, die oberhalb der höchsten Messfrequenz des NMR-Probenkopfes 1 liegt. Die axiale Länge der Wellenleiter 7 parallel zur Rohrachse sollte insbesondere derart gewählt werden, dass elektromagnetische Wellen um mehr als 60dB gedämpft sind.

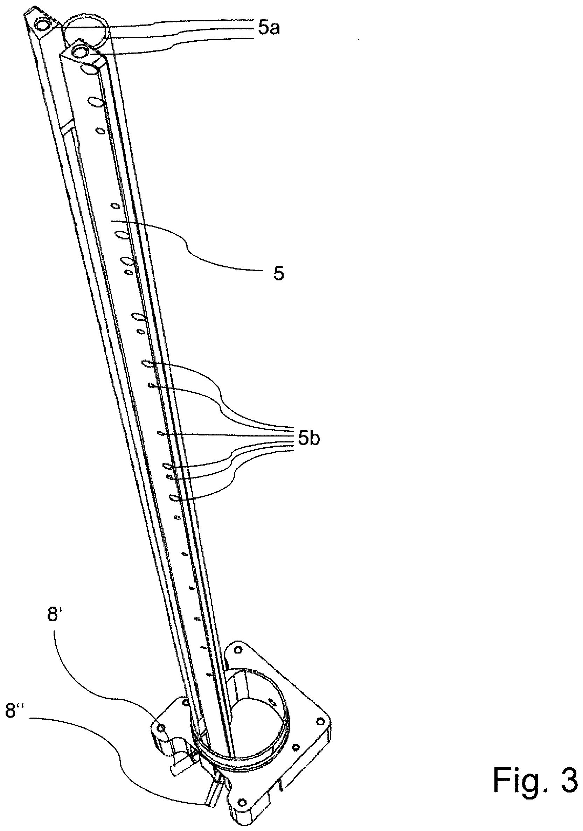

In der räumlichen (aber immer noch schematischen) Darstellung der **Figur 3** ist eine spezielle geometrische Ausgestaltung des Trageteils 5 zu erkennen, welches **Querbohrungen 5b** aufweist, an denen weitere Bauteile des NMR-Probenkopfes 1, etwa elektrische Zuleitungen oder HF-Bauteile, befestigt werden können. Diese Querbohrungen 5b können der Verschraubung beispielsweise der HF-Elektronik und werden vorzugsweise auf ganzer Länge des Trageteils 5 vorgehalten, insbesondere in regelmäßigen axialen Abständen in Richtung der Rohrachse. Die etwas größere Bohrung 5a im oberen Bereich der Figur kann wiederum als ein Dewar-Kanal ausgebildet sein. Zu den beiden kleineren an der Figur-Oberseite erkennbaren Bohrungen 5a führen an der Bild-Unterseite eine **pneumatische Zuleitung 8'** sowie eine **thermischen Zuleitung 8".** Diese sind vor allem bei MAS-Anwendungen erforderlich, um Druckluft für den Rotationsbetrieb des MAS-Moduls sowie temperiertes Fluid zur Temperierung der Messprobe vom Anschlussbereich 4 in den Spulenbereich 2 zu führen.

Durch die räumlich zusammenhängende Kontur zwischen Trageteil 5 und Abschirmrohr 3 ergibt sich eine Geometrie, die einem Wabenkamin entspricht, der die eintretenden elektromagnetischen Wellen entlang einer in z-Richtung längs der Rohrachse verlaufenden Dämpfungsstrecke dämpft. Die Bohrungen 5a haben eine elektrisch leitfähige Innenoberfläche, sodass Störungen, die durch teilweise in die Bohrungen eingeführte leitfähigen Metalldrähte (beispielsweise von einem Dewar mit Heizwendel, der bis zur Mitte des Trageteils 5 geführt ist) gedämpft werden.

Wichtig ist, dass Trageteil 5 und Abschirmrohr 3 eine zusammenhängende elektrisch leitfähige bzw. metallische Kontur bilden, die vom Spulenbereich 2 bis zum Anschlussbereich 4 entlang der z-Richtung elektrisch verbunden ist. Diese Verbindung soll aber auch -mechanisch- leicht trennbar sein, da sie ja aus getrennten Bauteilen aufgebaut ist, die möglicherweise einer getrennten Wartung bedürfen. Durch diese gemeinsame metallisch leitende Kontur bilden sich mehrere Wellenleiter 7 in z-Richtung aus, die unterschiedliche Geometrien haben können. Die Bohrungen 5a im Trageteil 5 haben vorzugsweise einen kreisförmigen Querschnitt und stellen somit einen Rundhohlleiter dar, vorzugsweise mit einem Durchmesser von 1mm bis 15mm, je nach Verwendung.

Zwischen Trageteil 5 und Abschirmrohr 3 bilden sich je nach Geometrie des Trageteils 5 und der Art und Anzahl der elektrisch leitfähigen Verbindungelemente 6 zwischen Trageteil 5 und Abschirmrohr 3 ein oder mehrere Wellenleiter 7 mit komplexeren Querschnittsgeometrien aus.

Für die elektrische Verbindung vom Trageteil zum Abschirmrohr können beispielsweise leitfähige Kunststoffe oder mit leitfähigem Gewebe überzogene Schaumstoffe verwendet werden. Diese haben allerdings den Nachteil, dass der Übergangswiderstand relativ groß ist. Daher werden bevorzugt Federelemente mit elektrisch gut leitfähigem Material, insbesondere Kupfer-Beryllium-Federn eingesetzt und zwar in kurzen Abständen auf dem Trageteil 5, insbesondere im Abstand von vorzugsweise 0,5cm bis maximal 2cm auf der ganzen Länge des Trageteils 5, so dass der Übergangswiderstand möglichst gering gehalten wird. Wenn diese Federn beiderseits auf im Wesentlichen gegenüberliegenden Seiten des Trageteils 5 befestigt werden, kann durch gegenseitigen Andruck der elektrische Kontakt von Trageteil 5 zum Abschirmrohr 3 erhöht werden. Des Weiteren kann sich das Abschirmrohr 3 auf diese Weise gut zentrieren.

Nicht alle Zuleitungen verlaufen in den Bohrungen 5a. So sind etwa -wie in den Figuren 1 und 2 erkennbar- die **Koaxialkabel 10** zur HF-Spulenanordnung 2a vorzugsweise an der Außenwandung des Trageteils 5 mechanisch und elektrisch leitend verbunden.

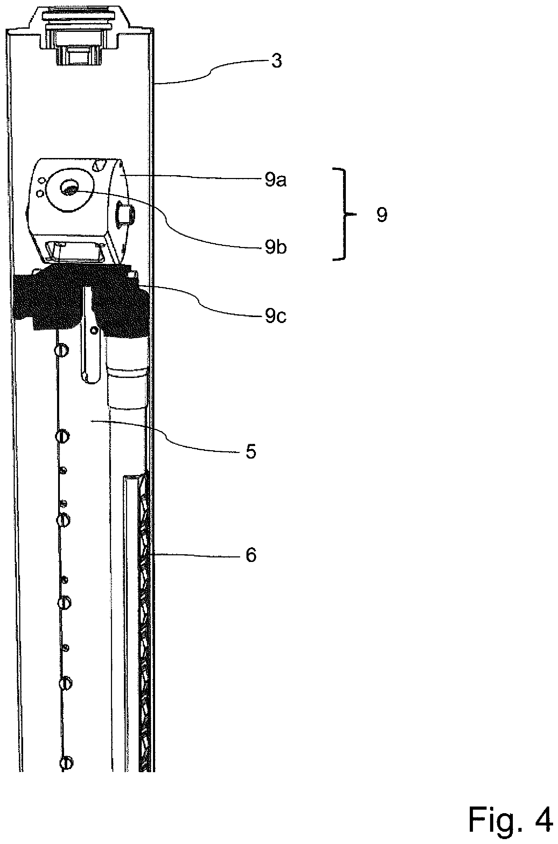

Vorzugsweise ist das Trageteil 5 als Strangpressprofil oder als Druckprofil mit integrierten pneumatischen Kanälen 5a hergestellt. Ein solches Strangpressprofil ist kostengünstig in unterschiedlichen Längen erhältlich und relativ einfach zu bearbeiten. Vorzugsweise besteht es aus Aluminium. Durch eine im Querschnitt gewinkelte oder abgerundete, konkave Struktur erhält das Trageteil 5 eine hohe Eigensteifheit, sodass keine weiteren Verstärkungen erforderlich sind. Dies ist notwendig, um eine genaue Positionierung der HF-Spulenanordnung 2a und insbesondere eines **MAS-Moduls 9** mit **MAS-Stator 9a** und **MAS-Rotor 9b** zu gewährleisten, wie sie in der räumlichen Darstellung der **Figur 4** zu erkennen sind. Gleiches gilt für die Befestigung der Komponenten, die vorzugsweise seitlich am Trageteil 5 angeschraubt werden können.

Innerhalb des Trageteils 5 sind auch solche Bohrungen 5a eingebracht, die flüssige oder gasförmige Medien (z.B. Druckluft oder Temperierfluide) vom Anschlussbereich 4 bis zum Spulenbereich 2 transportieren können. Auch andere Kanäle, z.B. für die Durchführung von Sensoren oder zusätzlichen Isolationen (z.B. mit einem Dewar) können in dem Trageteil 5 vorgesehen sein. Durch die Ausführung aus leitfähigem Material können innerhalb der Kanäle auch andere Komponenten, wie z.B. Heizdrähte oder Temperatursensoren angebracht werden, ohne dabei die Isolation des Probenkopf-Inneren gegenüber externen Störsignalen zu beeinträchtigen. Temperatursensordrähte, die bis in den Messbereich hineinragen, sollten am oberen Ende des Trageteils mit elektrisch leitfähigem Material abgedichtet werden, z.B. durch Verlöten, da ansonsten ein Koaxialleiter entsteht. Heizdrähte enden typischerweise auf halber Strecke im Trageteil, wodurch noch ausreichend Dämpfungsstrecke vorhanden ist.

Im Falle von MAS-Probenköpfen schließt sich am oberen Ende des Trageteils 5 eine **Verteilerkappe 9c** an, welche als Adapterstück die Verbindungen im Trageteil mit dem MAS-Modul 9, genauer mit dem MAS-Stator 9a herstellt und abdichtet. Dadurch wird das MAS Modul 9 ausgerichtet und richtig positioniert. Diese Verbindung kann auch für Anwendungen in deutlich über oder erheblich unterhalb der Zimmertemperatur liegenden Temperaturbereichen geeignet sein.

Optional umfasst das Trageteil 5 auch Bohrungen 5a, an welchen weitere Bauteile befestigt werden können. Die Bohrungen 5a können, wie bereits oben ausgeführt, auf der ganzen axialen Länge und vorzugsweise in regelmäßigen Abständen vorgesehen sein, ähnlich wie bei einem Regal, an welchem die Regalböden auf beliebiger Höhe befestigt werden können. Sollten weitere metallische Bauteile durch den Probenkopf 1 geführt werden, können diese somit gleichzeitig und mit dem geforderten Mindestabstand geerdet werden.

Ebenfalls optional umfasst das Trageteil 5 auch Bohrungen 5a oder Ausprägungen, die eine Verstellachse führen und/oder lagern können (z.B. die Winkelverstellachse für den MAS-Stator 9a).

Zusammen mit dem Abschirmrohr 3 und einer Bodenplatte, kann das Trageteil 5 gegen die Umgebung abgedichtet werden, so dass das komplette Innere des Probenkopfes 1 unter Über- oder Unterdruck gesetzt werden kann.

Die wiederum sehr schematisch gehaltene Darstellung der **Figur 5** schließlich zeigt ein **NMR-Magnetsystems 20** mit **B₀-Spulen 21** zur Erzeugung des statischen NMR-Magnetfelds, dessen **Feldlinien 22** in der Zeichnung ebenfalls angedeutet sind. Derartige Anordnungen sind prinzipiell aus dem Stand der Technik bekannt. Der Spulenbereich 2 eines Probenkopfes 1 ist hier in einem NMR-Messbetriebszustand in einem Messbereich um ein **magnetisches Zentrum 23** innerhalb der -der Übersichtlichkeit halber nicht eigens dargestellten- Magnetbohrung des NMR-Magnetsystems 20 angeordnet. Innerhalb des Abschirmrohrs 3 des Probenkopfes 1 ist im oberen, in das magnetische Zentrum 23 hineinragende Teil ein erster **Bauraum 24 für HF-Elektronik** und im daran anschließenden unteren Teil, welcher in den als Fußkasten ausgestalteten Anschlussbereich 4 führt, ein zweiter **Bauraum 25 für Zuleitungen** angedeutet.

### Bezugszeichenliste:

- 1: NMR-Probenkopf
- 2: Spulenbereich
- 2a: HF-Spulenanordnung
- 3: Abschirmrohr
- 4: Anschlussbereich
- 5: Trageteil
- 5a: Bohrungen und Verbindungskanäle
- 5b: Querbohrungen
- 6: elektrisch leitfähige Verbindungselemente
- 7: Wellenleiter
- 8': pneumatischen Zuleitungen
- 8": thermischen Zuleitungen
- 9: MAS-Modul
- 9a: MAS-Stator
- 9b: MAS-Rotor
- 9c: Verteilerkappe
- 10: Koaxialkabel zur HF-Spule
- 20: NMR-Magnetsystem
- 21: B0-Magnetspulen
- 22: magnetische Feldlinien
- 23: Messbereich = magnetisches Zentrum
- 24: Bauraum für HF-Elektronik
- 25: Bauraum für Zuleitungen

### Referenzliste

Für die Beurteilung der Patentfähigkeit in Betracht gezogene Publikationen:
[0] Volker C. Behr ET AL: "A novel modular probe base design", CONCEPTS IN MAGNETIC RESONANCE PART B: MAGNETIC RESONANCE ENGINEERING, Bd. 33B, Nr. 1, 1. Januar 2008 (2008-01-01), Seiten 55-61, XP055602704, US ISSN: 1552-5031, D01: 10.1002/cmr.b.20107
[1] DE 10 2013 201 110 B3
[2] US 5,262,727 A
[3] US 6,329,820 B1
[4] Patent Abstracts of Japan 05307073 A
[5] DE 10 2017 208 841.9
[6] US 2014/0167756 A1
[7] DE 10 2005 025 012 B4

## Patentansprüche

1. NMR-Probenkopf (1) zum Einführen in eine Magnetbohrung eines NMR-Magnetsystems (20), wobei der NMR-Probenkopf (1) in einem Spulenbereich (2) eine HF-Spulenanordnung (2a) umfasst, die zum Einstrahlen von HF-Pulsen in eine NMR-Messprobe und/oder zum Empfangen von HF-Signalen aus der NMR-Messprobe dient und in einem NMR-Messbetriebszustand in einem Messbereich um ein magnetisches Zentrum (23) innerhalb der Magnetbohrung angeordnet ist, wobei der NMR-Probenkopf (1) ein längliches Abschirmrohr (3) aus elektrisch leitfähigem Material zum Abschirmen gegen äußere HF-Strahlung umfasst, welches die elektrischen, mechanischen und HF-Bauteile des NMR-Probenkopfes (1) umgibt und durch welches Zuleitungen von einem im NMR-Messbetriebszustand außerhalb des Messbereiches angeordneten Anschlussbereich (4) zum Spulenbereich (2) geführt sind, wobei innerhalb des Abschirmrohrs (3) ein längliches Trageteil (5) angeordnet ist, welches eine eigensteife, mechanisch starre Struktur mit durchgängigen, im Wesentlichen parallel zur Längsachse des Abschirmrohrs (3) verlaufenden Bohrungen und/oder Verbindungskanälen (5a) aufweist, die im Anschlussbereich (4) elektrische Zuleitungen aufnehmen und zum Spulenbereich (2) führen, und wobei das längliche Trageteil (5) eine vom Anschlussbereich (4) bis zum Spulenbereich (2) führende durchgehend elektrisch leitfähige äußere Oberfläche aufweist,
**dadurch gekennzeichnet,**
**dass** die vom Anschlussbereich (4) bis zum Spulenbereich (2) führende durchgehend elektrisch leitfähige äußere Oberfläche des länglichen Trageteils (5) mit der elektrisch leitfähigen Innenfläche des Abschirmrohrs (3) über elektrisch leitfähige Verbindungselemente (6) elektrisch leitend verbunden ist,
und **dass** Trageteil (5) und Abschirmrohr (3) so miteinander verbunden sind, dass sich eine zusammenhängende elektrisch leitfähige Kontur ausbildet, die vom Spulenbereich bis zum Anschlussbereich verläuft und die Funktion eines Wabenkamins zur Dämpfung elektromagnetischer Felder hat.

2. Probenkopf nach Anspruch 1, **dadurch gekennzeichnet, dass** der Anschlussbereich (4) als Fußkasten ausgebildet ist.

3. Probenkopf nach Anspruch 1 oder 2, **dadurch gekennzeichnet, dass** die gemeinsame elektrische Kontur zwischen Trageteil (5) und Abschirmrohr (3) mehrere Wellenleiter (7) parallel zur Rohrachse des Abschirmrohrs (3) umfasst, die in ihrer Querschnittsfläche so dimensioniert sind, dass jeder Wellenleiter (7) eine Grenzfrequenz aufweist, die oberhalb der höchsten Messfrequenz des NMR-Probenkopfes (1) liegt.

4. Probenkopf nach Anspruch 3, **dadurch gekennzeichnet, dass** die Länge der Wellenleiter (7), die sich aus der gemeinsamen elektrischen Kontur ergeben, derart gewählt ist, dass elektromagnetische Wellen um mehr als 60dB gedämpft sind.

5. Probenkopf nach einem der vorhergehenden Ansprüche, **dadurch gekennzeichnet, dass** der NMR-Probenkopf (1) als NMR-MAS Probenkopf ausgebildet ist und einen im NMR-Messbetriebszustand innerhalb des Messbereichs angeordneten MAS-Modul (9) mit einem MAS-Stator (9a) umfasst, in welchem während einer NMR-Messung ein MAS-Rotor (9b) einschließlich einer NMR-Messprobe Druckgas-gelagert und temperierbar positioniert ist und mit Hilfe eines Gasstroms rotiert werden kann.

6. Probenkopf nach Anspruch 5, **dadurch gekennzeichnet, dass** im MAS-Modul-seitigen Ende des Trageteils (5) eine als Adaptereinrichtung gestaltete Verteilerkappe (9c) angeordnet ist, welche die Enden der durchgängigen Bohrungen und/oder Verbindungskanäle (5a) des Trageteils (5) mit entsprechenden Anschlüssen für die elektrischen sowie auch die pneumatischen und thermischen Zuleitungen (8'; 8") am MAS-Modul (9), vorzugsweise pneumatisch und thermisch dichtend, verbindet.

7. Probenkopf nach einem der vorhergehenden Ansprüche, **dadurch gekennzeichnet, dass** die Verbindungskanäle (5a) auch, vorzugsweise sämtliche, pneumatischen Zuleitungen (8') und thermischen Zuleitungen (8") aufnehmen und vom Anschlussbereich (4) bis zum Spulenbereich (2) führen.

8. Probenkopf nach einem der vorhergehenden Ansprüche, **dadurch gekennzeichnet, dass** die vom Anschlussbereich (4) bis zum Spulenbereich (2) führende, durchgehend elektrisch leitfähige äußere Oberfläche mittels eines Massebands mit dem Erdpotential elektrisch verbunden ist.

9. Probenkopf nach einem der vorhergehenden Ansprüche, **dadurch gekennzeichnet, dass** das längliche Trageteil (5) einstückig aufgebaut ist.

10. Probenkopf nach Anspruch 9, **dadurch gekennzeichnet, dass** das längliche Trageteil (5) eine im Querschnitt gewinkelte oder abgerundete, konkave Struktur aufweist.

11. Probenkopf nach Anspruch 9 oder 10, **dadurch gekennzeichnet, dass** das längliche Trageteil (5) insgesamt aus leitfähigem Material, vorzugsweise aus Metall, aufgebaut ist.

12. Probenkopf nach Anspruch 11, **dadurch gekennzeichnet, dass** das längliche Trageteil (5) aus einem Strangpressprofil oder Druckprofil mit integrierten durchgehenden Kanälen (5a) für pneumatische und/oder elektrische und/oder thermische Verbindungen aufgebaut ist.

13. Probenkopf nach einem der vorhergehenden Ansprüche, **dadurch gekennzeichnet, dass** das längliche Trageteil (5) gemeinsam mit dem Abschirmrohr (3) gegen die Umgebung zumindest pneumatisch, vorzugsweise auch thermisch, abgedichtet ist.

14. Probenkopf nach einem der vorhergehenden Ansprüche, **dadurch gekennzeichnet, dass** das längliche Trageteil (5) Querbohrungen (5b) aufweist, an welchen weitere Bauteile des NMR-Probenkopfes (1) befestigt werden können.

15. Probenkopf nach Anspruch 14, **dadurch gekennzeichnet, dass** die Querbohrungen (5b) auf ganzer Länge des Trageteils (5), vorzugsweise in regelmäßigen axialen Abständen, vorgesehen sind.

## Claims

1. An NMR probe head (1) for insertion into a magnet bore of an NMR magnet system (20), wherein the NMR probe head (1) comprises, in a coil region (2), an RF coil arrangement (2a) which is used to irradiate RF pulses into an NMR measurement sample and/or to receive RF signals from the NMR measurement sample and, in an NMR measurement operating state, is arranged in a measurement region around a magnetic center (23) inside the magnet bore, wherein the NMR probe head (1) comprises an elongated shielding tube (3) made of electrically conductive material for shielding against external RF radiation, which shielding tube surrounds the electrical, mechanical and RF components of the NMR probe head (1) and through which supply lines are led from a connection region (4) arranged outside the measurement region in the NMR measurement operating state to the coil region (2),
wherein an elongated backbone (5) is arranged inside the shielding tube (3) and has an inherently rigid, mechanically stiff structure having continuous bores and/or connecting channels (5a) which run substantially parallel to the longitudinal axis of the shielding tube (3) and accommodate electrical supply lines in the connection region (4) and lead them to the coil region (2), and wherein the elongated backbone (5) has a continuously electrically conductive outer surface which leads from the connection region (4) to the coil region (2)
**characterized in that**
the continuous electrically conductive outer surface of the elongated backbone (5) leading from the connection region (4) to the coil region (2) is connected in an electrically conductive manner to the electrically conductive inner surface of the shielding tube (3) via electrically conductive connecting elements (6),
and that the backbone (5) and the shielding tube (3) are connected to one another such that a continuous electrically conductive contour is formed that leads from the coil region to the connection region and has the function of a honeycomb vent for damping electromagnetic fields.

2. The probe head as claimed in claim 1, **characterized in that** the connection region (4) is in the form of a pedestal box.

3. The probe head as claimed in claim 1 or 2, **characterized in that** the common electrical contour between the backbone (5) and the shielding tube (3) comprises a plurality of waveguides (7) parallel to the tube axis of the shielding tube (3), the cross-sectional area of which waveguides is dimensioned in such a manner that each waveguide (7) has a cut-off frequency which is above the highest measurement frequency of the NMR probe head (1).

4. The probe head as claimed in claim 3, **characterized in that** the length of the waveguides (7) resulting from the common electrical contour is selected in such a manner that electromagnetic waves are attenuated by more than 60 dB.

5. The probe head as claimed in one of the preceding claims, **characterized in that** the NMR probe head (1) is in the form of an NMR MAS probe head and comprises an MAS module (9) with an MAS stator (9a), which MAS module is arranged inside the measurement region in the NMR measurement operating state and in which an MAS rotor (9b), including an NMR measurement sample, is positioned in a manner mounted using compressed gas and in a temperature-controllable manner during an NMR measurement and can be rotated with the aid of a gas flow.

6. The probe head as claimed in claim 5, **characterized in that** a distributor cap (9c) in the form of an adapter device is arranged at the MAS-module-side end of the backbone (5) and connects the ends of the continuous bores and/or connecting channels (5a) of the backbone (5) to corresponding connections for the electrical as well as the pneumatic and thermal supply lines (8'; 8") on the MAS module (9), preferably with pneumatic and thermal sealing.

7. The probe head as claimed in one of the preceding claims, **characterized in that** the connecting channels (5a) also accommodate, preferably all, pneumatic supply lines (8') and thermal supply lines (8") and lead them from the connection region (4) to the coil region (2).

8. The probe head as claimed in one of the preceding claims, **characterized in that** the continuously electrically conductive outer surface leading from the connection region (4) to the coil region (2) is electrically connected to the ground potential by means of a ground strap.

9. The probe head as claimed in one of the preceding claims, **characterized in that** the elongated backbone (5) is constructed in one piece.

10. The probe head as claimed in claim 9, **characterized in that** the elongated backbone (5) has a concave structure with an angled or rounded cross section.

11. The probe head as claimed in claim 9 or 10, **characterized in that** the elongated backbone (5) is constructed overall from conductive material, preferably metal.

12. The probe head as claimed in claim 11, **characterized in that** the elongated backbone (5) is constructed from an extruded profile or compression profile with integrated continuous channels (5a) for pneumatic and/or electrical and/or thermal connections.

13. The probe head as claimed in one of the preceding claims, **characterized in that** the elongated backbone (5), together with the shielding tube (3), is sealed with respect to the environment, at least pneumatically, preferably also thermally.

14. The probe head as claimed in one of the preceding claims, **characterized in that** the elongated backbone (5) has transverse bores (5b) at which further components of the NMR probe head (1) can be fastened.

15. The probe head as claimed in claim 14, **characterized in that** the transverse bores (5b) are provided over the entire length of the backbone (5), preferably at regular axial intervals.

## Revendications

1. Tête de sonde RMN (1) destinée à être insérée dans un alésage d'aimant d'un système d'aimant RMN (20), dans laquelle la tête de sonde RMN (1) comprend un agencement de bobine HF (2a) dans une zone de bobine (2), lequel sert à rayonner des impulsions HF dans un échantillon de mesure RMN et/ou à recevoir des signaux HF en provenance de l'échantillon de mesure RMN et qui, dans un mode de mesure RMN, est agencé dans une zone de mesure entourant un centre magnétique (23) à l'intérieur de l'alésage d'aimant, dans laquelle la tête de sonde RMN (1) comprend un tube de blindage allongé (3) en matériau électriquement conducteur pour le blindage contre le rayonnement HF externe, lequel entoure des composants électriques, mécaniques et HF de la tête de sonde RMN (1) et à travers lequel des lignes d'alimentation provenant d'une zone de raccordement (4) agencée à l'extérieur de la zone de mesure dans le mode de mesure RMN sont acheminées vers la zone de bobine (2), dans laquelle une partie de support allongée (5) est agencée à l'intérieur du tube de blindage (3), laquelle présente une structure intrinsèquement rigide, mécaniquement résistante, avec des alésages et/ou des canaux de connexion (5a) continus s'étendant sensiblement parallèlement à l'axe longitudinal du tube de blindage (3), lesquels reçoivent des lignes d'alimentation électriques dans la zone de raccordement (4) et mènent à la zone de bobine (2), et dans laquelle la partie de support allongée (5) présente une surface extérieure continue électriquement conductrice menant de la zone de raccordement (4) à la zone de bobine (2),
**caractérisée en ce que**
la surface extérieure continue électriquement conductrice de la partie de support allongée (5) menant de la zone de raccordement (4) à la zone de bobine (2) est connectée de manière électriquement conductrice à la surface intérieure électriquement conductrice du tube de blindage (3) par l'intermédiaire d'éléments de connexion électriquement conducteurs (6),
et **en ce que** la partie de support (5) et le tube de blindage (3) sont reliés l'un à l'autre de manière à former un contour électriquement conducteur continu qui s'étend de la zone de bobine à la zone de raccordement et qui remplit la fonction d'une cheminée en nid d'abeille destinée à atténuer les champs électromagnétiques.

2. Tête de sonde selon la revendication 1, **caractérisée en ce que** la zone de raccordement (4) est réalisée sous la forme d'un coffre de pied.

3. Tête de sonde selon la revendication 1 ou 2, **caractérisée en ce que** le contour électrique commun entre la partie de support (5) et le tube de blindage (3) comprend une pluralité de guides d'ondes (7) parallèles à l'axe de tube du tube de blindage (3), dont les surfaces de section transversale sont dimensionnées de telle sorte que chaque guide d'ondes (7) présente une fréquence de coupure qui se situe au-dessus de la fréquence de mesure la plus élevée de la tête de sonde RMN (1).

4. Tête de sonde selon la revendication 3, **caractérisée en ce que** la longueur des guides d'ondes (7) qui résultent du contour électrique commun est sélectionnée de telle sorte que les ondes électromagnétiques soient atténuées de plus de 60 dB.

5. Tête de sonde selon l'une quelconque des revendications précédentes, **caractérisée en ce que** la tête de sonde RMN (1) est réalisée sous la forme d'une tête de sonde RMN-MAS et comprend un module MAS (9) agencé à l'intérieur de la zone de mesure dans le mode de mesure RMN et présentant un stator MAS (9a) dans lequel, lors d'une mesure RMN, un rotor MAS (9b) contenant un échantillon de mesure RMN est positionné de manière exposée à un gaz sous pression et régulée en température et qu'il puisse être mis en rotation à l'aide d'un flux de gaz.

6. Tête de sonde selon la revendication 5, **caractérisée en ce que**, dans l'extrémité de la partie de support (5) située du côté du module MAS, est agencé un capuchon de distribution (9c) conçu sous la forme d'un dispositif d'adaptation, lequel relie les extrémités des alésages et/ou des canaux de raccordement traversants (5a) de la partie de support (5) à des raccords correspondants pour les lignes d'alimentation électriques ainsi que pneumatiques et thermiques (8' ; 8") sur le module MAS (9), de préférence de manière pneumatiquement et thermiquement étanche.

7. Tête de sonde selon l'une quelconque des revendications précédentes, **caractérisée en ce que** les canaux de raccordement (5a) reçoivent également, de préférence en totalité, des lignes d'alimentation pneumatiques (8') et des lignes d'alimentation thermiques (8") et mènent de la zone de raccordement (4) à la zone de bobine (2).

8. Tête de sonde selon l'une quelconque des revendications précédentes, **caractérisée en ce que** la surface extérieure continue électriquement conductrice menant de la zone de raccordement (4) à la zone de bobine (2) est électriquement connectée au potentiel de la terre au moyen d'une bande de masse.

9. Tête de sonde selon l'une quelconque des revendications précédentes, **caractérisée en ce que** la partie de support allongée (5) est réalisée en une seule pièce.

10. Tête de sonde selon la revendication 9, **caractérisée en ce que** la partie de support allongée (5) présente une structure concave angulaire ou arrondie en section transversale.

11. Tête de sonde selon la revendication 9 ou 10, **caractérisée en ce que** la partie de support allongée (5) est entièrement réalisée en matériau conducteur, de préférence en métal.

12. Tête de sonde selon la revendication 11, **caractérisée en ce que** la partie de support allongée (5) est réalisée à partir d'un profilé extrudé ou d'un profilé sous pression avec des canaux traversants intégrés (5a) destinés à des connexions pneumatiques et/ou électriques et/ou thermiques.

13. Tête de sonde selon l'une quelconque des revendications précédentes, **caractérisée en ce que** la partie de support allongée (5), conjointement avec le tube de blindage (3), est rendue étanche à l'environnement au moins pneumatiquement, de préférence également thermiquement.

14. Tête de sonde selon l'une quelconque des revendications précédentes, **caractérisée en ce que** la partie de support allongée (5) présente des alésages transversaux (5b) auxquels peuvent être fixés d'autres composants de la tête de sonde RMN (1).

15. Tête de sonde selon la revendication 14, **caractérisée en ce que** les alésages transversaux (5b) sont prévus sur toute la longueur de la partie de support (5), de préférence à des intervalles axiaux réguliers.
